# EUROPEAN PATENT SPECIFICATION

(11) **EP 3 674 602 B1**
(45) Date of publication and mention of the grant of the patent: **20.10.2021**
(21) Application number: 19182374.9
(22) Date of filing: 25.06.2019
(51) Int. Cl.: F21S 43/20, F21S 43/33, F21V 9/00

(54) **LAMP DEVICE**
LAMPENVORRICHTUNG
DISPOSITIF DE LAMPE

(30) Priority: 27.12.2018 TW 107147469
(43) Date of publication of application: 01.07.2020
(73) Proprietor: T.Y.C. Brother Industrial Co., Ltd., Tainan City 70248 (TW)
(72) Inventor: LIN, Min-Feng, 70248 Tainan City (TW); LIN, Nan-Ming, 81166 Kaohsiung City (TW)
(74) Representative: Stöckeler, Ferdinand

(56) References cited:
- EP-A1- 2 071 232
- EP-A1- 3 165 811
- EP-A1- 3 385 611
- WO-A2-2016/166193
- US-A1- 2016 018 080

## Description

The invention relates to a lamp device, more particularly to a lamp device for a vehicle.

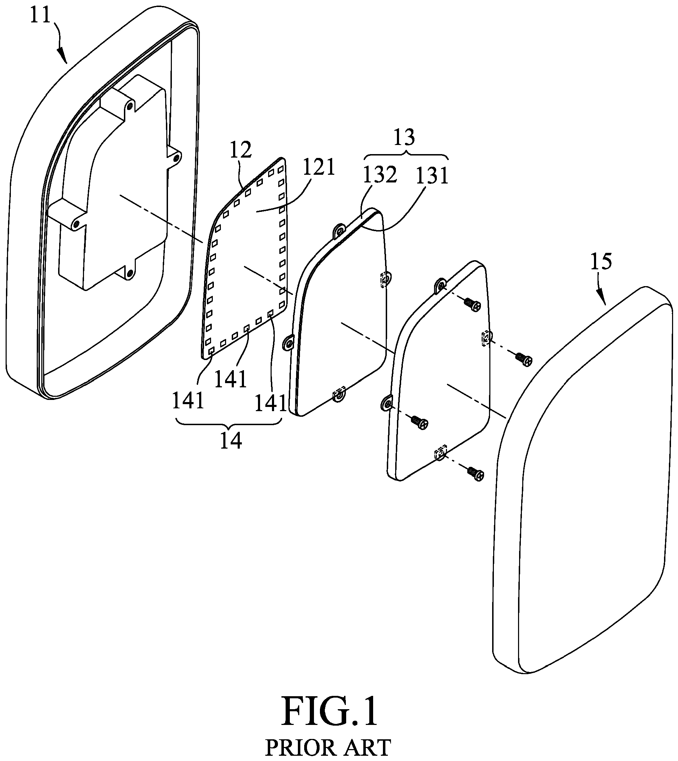

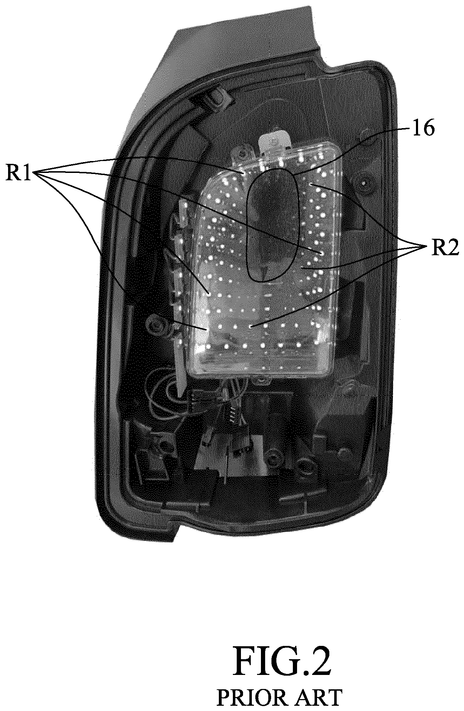

Referring to FIGS. 1 and 2, a conventional lamp device used as a tail light installed at the rear of a car is illustrated. The conventional lamp device includes a lamp seat 11, a first support member 12, a reflecting module 13, a light emitting unit 14 mounted to the first support member 12, and a lamp shield 15 mounted rearwardly to the lamp seat 11 to shield the first support member 12, the reflecting module 13 and the light emitting unit 14. The first support member 12 and the reflecting module 13 are mounted to the lamp seat 11 and are disposed along a front-rear direction.

The first support member 12 is made of steel and has a polished reflecting surface 121. The reflecting surface 121 has a reflectivity of less than 60% for visible light. The reflecting module 13 includes a semi-reflecting film 131 and a second support member 132 that the semi-reflecting film 131 is formed on. The second support member 132 is made of a transparent material. The semi-reflecting film 131 has a reflectivity of approximately 40% to 80% for visible red light of wavelength ranging from 575 nm to 675 nm. The light emitting unit 14 includes a plurality of light emitting members 141 mounted in a ring shape on the first support member 12 and emitting visible red light.

The light pattern produced by the conventional lamp device is shown in FIG. 2. Other than the outermost ring of dotted red light indicated as R1 in FIG. 2, which is a real image produced directly from the light emitting members 141, the inner rings of dotted red light (indicated as R2 in FIG. 2) are virtual images produced through cooperation between the reflecting surface 121 and the semi-reflecting film 131. The real and virtual images cooperatively produce a three dimensional tunnel-like visual effect.

Even though the conventional lamp device can produce the three dimensional tunnel-like visual effect, the number of the inner rings of the virtual images is lacking, resulting a relative large dark region 16 in the center of the light pattern. Moreover, even though the semi-reflecting film 131 achieves semi-reflection with visible red light, it is unable to achieve the same for visible lights of other colors.

EP 2 071 232 A1 discloses a lamp assembly comprising a reflector having a mirrored surface oriented axially to face a field to be illuminated. A partially light reflective and partially light transmissive lens (140) having a first surface facing the reflector is offset from the mirrored surface to form a cavity therebetween. At least one LED light source is positioned near the cavity and oriented to direct light into the cavity intermediate the reflector and the lens. An electro-mechanical transformer providing a mechanical output in response to an electrical input signal is mechanically attached to the mirror.

US 2016/018080 A1 teaches a thin-film reflective stack including multiple layers positioned directly on a reflecting layer provided on a base reflector surface. The layers are alternating relatively high and relatively low index oxides.

Therefore, the object of the invention is to provide a lamp device that can alleviate at least one of the drawbacks of the prior art.

The invention provides for a lamp device according to claim 1. Further developments of the invention are defined in the dependent claims.

According to the invention, a lamp device includes a reflecting unit and a light emitting unit.

The reflecting unit includes a first reflecting module and a second reflecting module. The first reflecting module is configured to reflect light towards the second reflecting module and has a reflectivity that is substantially over 70% for light of wavelength ranging from 550 nm to 800 nm. The second reflecting module is configured to reflect light towards the first reflecting module and has a reflectivity that substantially ranges from 50% to 75% for light of wavelength ranging from 460 nm to 700 nm.

The light emitting unit is connected to the reflecting unit and configured to emit light toward the reflecting unit in such a way that at least a part of the light emitted by the light emitting unit is reflected from one of the first reflecting module and the second reflecting module.

The second reflecting module includes a second support member that is light-transmissible and coupled to said first reflecting module, and a reflecting film that is deposited on said second support member and opposite to said first reflecting module, said reflecting film having a reflectivity substantially between 50% and 75% for light of wavelength ranging from 460 nm to 700 nm. The reflecting film includes a first deposited layer formed on said second support member, and second, third, fourth, fifth, sixth, seventh, eighth and nine deposited layers stacked in order on said first deposited layer in a direction away from said second support member, each of said first, third, fifth, seventh and ninth deposited layers having a refractive index of 2.28, each of said second, fourth, sixth, and eighth deposited layers having a refractive index of 1.45.

The first deposited layer has a thickness of 28.6 nm, said second deposited layer has a thickness of 19.5 nm, said third deposited layer has a thickness of 64.1 nm, said fourth deposited layer has a thickness of 165.0 nm, said fifth deposited layer has a thickness of 102.6 nm, said sixth deposited layer has a thickness of 94.4 nm, said seventh deposited layer has a thickness of 60.8 nm, said eighth deposited layer has a thickness of 96.7 nm, and said ninth deposited layer has a thickness of 60.0 nm

Other features and advantages of the invention will become apparent in the following detailed description of the embodiment and variations with reference to the accompanying drawings, of which:
FIG. 1 is an exploded perspective view of a conventional lamp device;
FIG. 2 is a photograph of a light pattern produced by the conventional lamp device;
FIG. 3 is an exploded perspective view of an embodiment of a lamp device according to the invention;
FIG. 4 is a sectional view of the embodiment;
FIG. 5 is a fragmentary sectional view, illustrating layers of a reflecting film of the embodiment;
FIG. 6 is a graph illustrating a reflectivity of an aluminum film of the embodiment for light of varying wavelength;
FIG. 7 is a graph illustrating a reflectivity of a reflecting film for light of different incident angles and varying wavelength;
FIG. 8 is a photograph illustrating a light pattern produced by the embodiment;
FIG. 9 is a fragmentary sectional view of a first variation of embodiment of the lamp device according to the invention;
FIG. 10 is a fragmentary sectional view of a second variation of the embodiment of the lamp device according to the invention;
FIG. 11 is a fragmentary sectional view of a third variation of the embodiment of the lamp device according to the invention;
FIG. 12 is a graph illustrating values of reflectivity of three combined film modules of respectively the first, second and third variations of the embodiment for varying wavelengths; and
FIG. 13 is a fragmentary sectional view of a fourth variation of the embodiment of the lamp device according to the invention.

Before the present invention is described in greater detail, it should be noted that where considered appropriate, reference numerals or terminal portions of reference numerals have been repeated among the figures to indicate corresponding or analogous elements, which may optionally have similar characteristics.

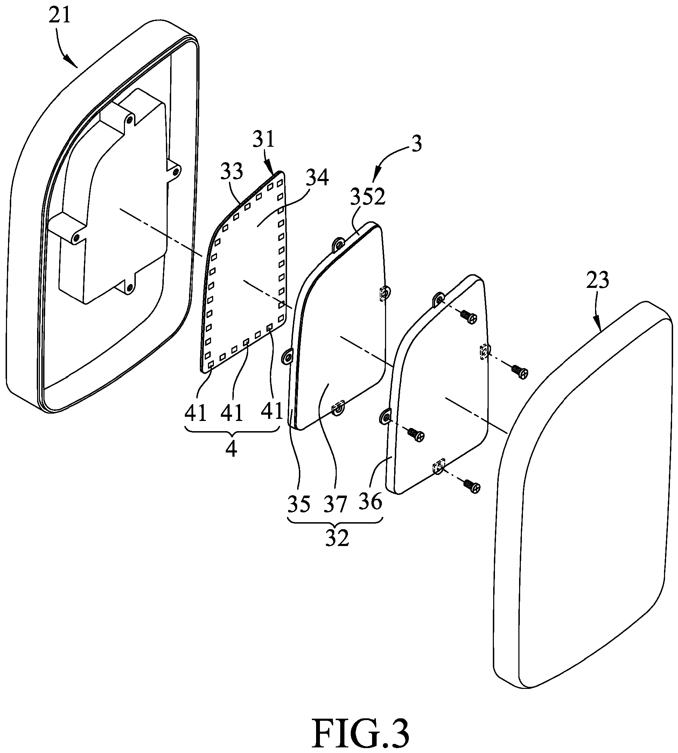

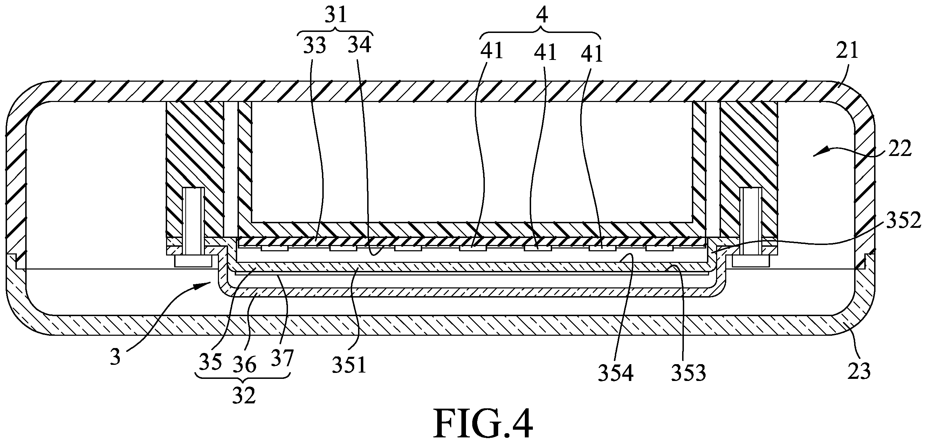

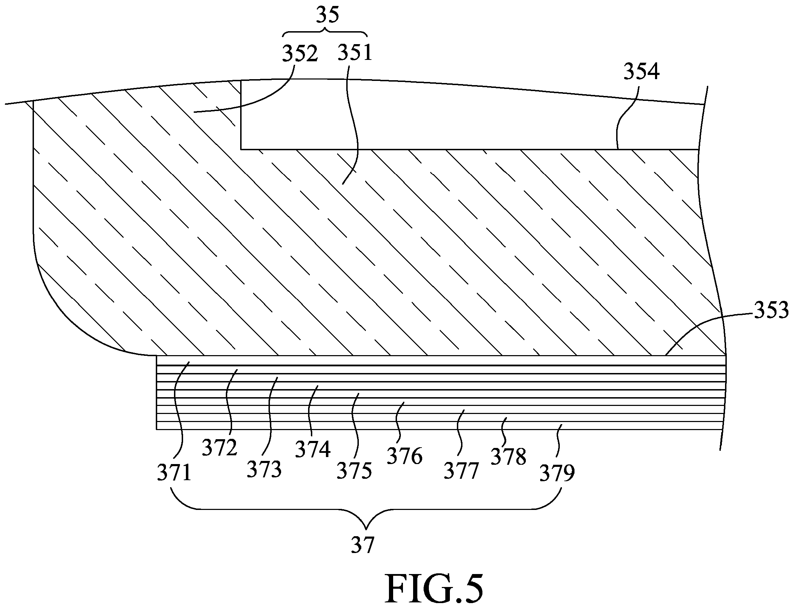

Referring to FIGS. 3 to 5, an embodiment of a lamp device according to the invention is exemplified as a vehicle lamp such as a taillight of automobiles or motorcycles.

The embodiment of the lamp device includes a lamp seat 21 adapted to be mounted to a vehicle, a lamp shield 23 mounted on the lamp seat 21 and cooperating with the lamp seat 21 to define a lamp space 22, a reflecting unit 3 mounted to the lamp seat 21 and received in the lamp space 22, and a light emitting unit 4 disposed on the reflecting unit 3. Light emitted from the light emitting unit 4 projects toward the lamp shield 2. The design and structure of the lamp seat 21 and the lamp shield 23 are well known to those skilled in the art and are omitted for the sake of brevity.

The reflecting unit 3 includes a first reflecting module 31 and a second reflecting module 32.

The first reflecting module 31 is configured to reflect light towards the second reflecting module 32 and has a reflectivity that is substantially over 70% for light of wavelength ranging from 550 nm to 800 nm. The first reflecting module 31 includes a first support member 33 and an aluminum film 34 deposited by evaporation on the first support member 33 and disposed between the first support member 33 and the second reflecting module 32. In this embodiment, the first support member 33 is substantially quadrilateral-shaped. The first support member 33 may be made of steel.

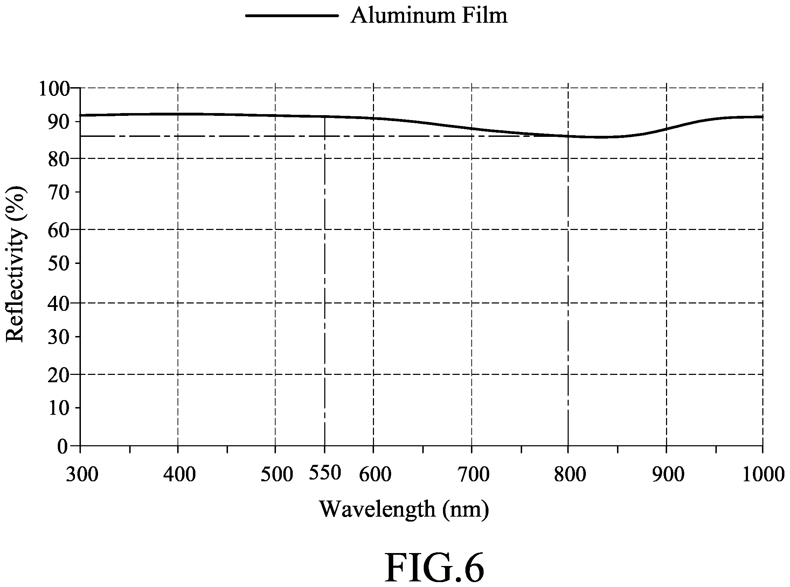

In this embodiment, the aluminum film 34 is formed on the first support member 33 through electron beam evaporation technique under pressure of 10⁻⁵ Torr and temperature of 60°C, using aluminum as a target and at an evaporation rate of 20Ǻ per second. Referring further to FIG. 6, reflectivity of the aluminum film 34 for light of varying wavelength is shown. For light with an incident angle of 0° (i.e., normal incidence) and of wavelength ranging from 550 nm to 800 nm, the aluminum film 34 has an average reflectivity that is substantially over 85%. For visible red light of wavelength ranging from 575 nm to 675 nm, the average reflectivity is approximately 90.8%.

The second reflecting module 32 is connected to the first reflecting module 31, configured to reflect light towards the first reflecting module 31, and has a reflectivity that substantially ranges from 50% to 75% for light of wavelength ranging from 460 nm to 700 nm. The second reflecting module 32 includes a second support member 35 that is light-transmissible and coupled to the first reflecting module 31, a light-transmissible shielding member 36 coupled to the second support member 35 and being opposite to the first reflecting module 31, and a reflecting film 37 that is deposited by evaporation on the second support member 35, opposite to the first reflecting module 31, and disposed between the second support member 35 and the light-transmissible shielding member 36.

In this embodiment, the second support member 35 is made of a light-transmissible material such as acrylics, and includes a plate portion 351 that may be substantially quadrilateral-shaped, and a supporting portion 352 extending from a periphery of the plate portion 351 toward the lamp seat 21 to be mounted to the lamp seat 21. The plate portion 351 includes a first surface 353 for the reflecting film 37 to be deposited on, and a second surface 354 opposite to the first surface 353 and facing the first reflecting module 31. In certain embodiments, the second surface 354 may be concave to achieve desired optical effects, but may vary in actual practice depending on differing needs.

The shielding member 36 is similar in shape to the second support member 35 but larger in size such that it shields over the rear of and protects the second support member 35 and the reflecting film 37.

The reflecting film 37 has a reflectivity substantially between 50% and 75% for light of wavelength ranging from 460 nm to 700 nm, and includes a first deposited layer 371 formed on the second support member 35, and second, third, fourth, fifth, sixth, seventh, eighth and nine deposited layers 372, 373, 374, 375, 376, 377, 378, 379 stacked in order on the first deposited layer 371 in a direction away from the second support member 35.

The reflecting film 37 is formed layer-by-layer using the electron beam evaporation technique, under a pressure of 10⁻⁵ torr and a temperature of 80°C, using either silica or titanium oxide targets, and at the evaporation rate of 8 Ǻ per second.

In this embodiment, each of the first, third, fifth, seventh and ninth deposited layers 371, 373, 375, 377, 379 is exemplified to be made of titanium dioxide and has a refractive index of 2.28. Each of the second, fourth, sixth, and eighth deposited layers 272, 274, 276, 278 is exemplified to be made of silica and has a refractive index of 1.45.

In this embodiment, the first deposited layer 371 has a thickness of 28.6 nm, the second deposited layer 372 has a thickness of 19.5 nm, the third deposited layer 373 has a thickness of 64.1 nm, the fourth deposited layer 374 has a thickness of 165.0 nm, the fifth deposited layer 375 has a thickness of 102.6 nm, the sixth deposited layer 376 has a thickness of 94.4 nm, the seventh deposited layer 377 has a thickness of 60.8 nm, the eighth deposited layer 378 has a thickness of 96.7 nm, and the ninth deposited layer 379 has a thickness of 60.0 nm.

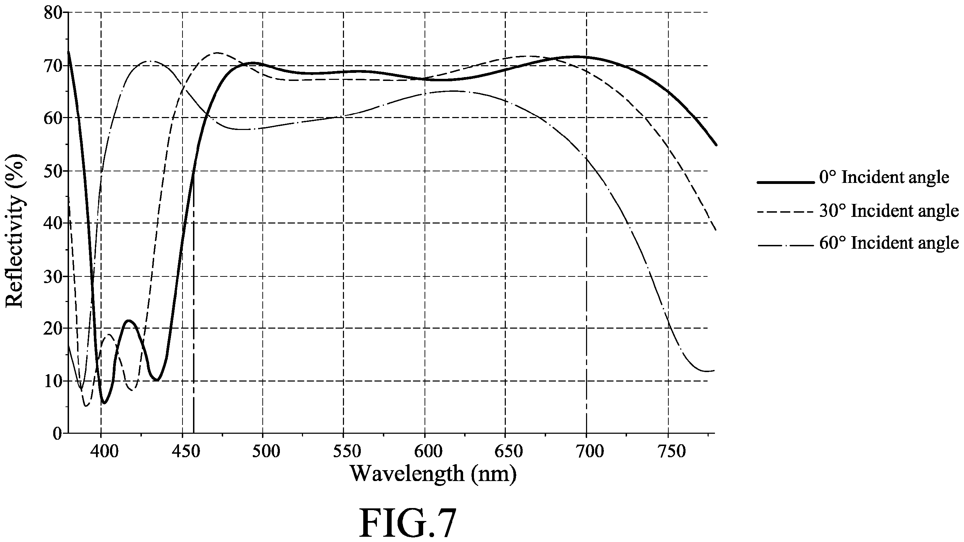

Referring to FIG. 7, the reflectivity of the reflecting film 37 for light of varying wavelength and at three different incident angles being 0°, 30°, and 60° was measured and plotted. During measurement, the reflecting film 37 is supported by a transparent substrate. From FIG. 7 it can be seen that the reflectivity of the reflecting film 37 for light of wavelength ranging from 460 nm to 700 nm is approximately 50% to 75%, providing desirable and relatively consistent semi-reflection.

In particular, for visible red light of wavelength ranging from 575 nm to 675 nm, when the angles of incidence are 0°, 30°, and 60°, the values of average reflectivity are respectively 68.2%, 69.1%, and 63.4%.

The light emitting unit 4 is connected to the reflecting unit 3 and configured to emit light toward the reflecting unit 3 in such a way that at least a part of the light emitted by the light emitting unit 4 is reflected from one of the first reflecting module 31 and the second reflecting module 32. In this embodiment, the light emitting unit 4 is connected to the first reflecting module 31 and emits the light toward the second reflecting module 32. The light emitting unit 4 includes a plurality of light emitting members 41 mounted to an outer ring portion of the first support member 33. In this embodiment, the light emitting members 41 are exemplified to be light emitting diodes that emit visible red light of wavelength ranging from 575 nm to 675 nm directed towards the first reflecting module 31.

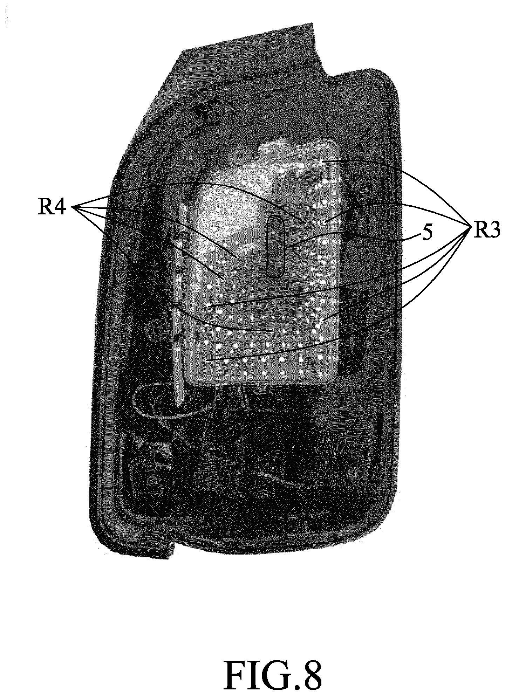

Referring to FIGS. 3, 4, and 8, a light pattern as shown in FIG. 8 can be produced by the embodiment. A portion of the light emitted by the light emitting members 41 transmits through the reflecting film 37 of the second reflecting module 32 to project into a user's eye, forming the outermost ring of dotted light (indicated as R3 in FIG. 8), and another portion of the light is reflected first by the reflecting film 37, then by the aluminum film 34 towards the reflecting film 37, where the another portion of the light partially transmits through the reflecting film 37 and is partially reflected by the reflecting film 37 again, and so on, forming multiple rings of dotted virtual image (indicated as R4 in FIG. 8) inside the outermost ring.

The aluminum film 34 of the embodiment has an average reflectivity of over 85% for light of wavelength ranging from 550 nm to 800 nm, which is higher than that of the conventional lamp device (less than 60%). The higher reflectivity allows the energy decay rate of the light to be reduced. Hence, in comparison to the light pattern of the conventional lamp device (see FIG. 2), the embodiment can produce more rings of dotted virtual image (see FIG. 8), reducing the area of a dark region 5 where no light can be seen. In other words, the embodiment produces better lighting than the conventional lamp device, having better warning effects and improving traffic safety.

Moreover, since the reflecting film 37 of the embodiment has reflectivity of 50% to 75% for light of wavelength ranging from 460 nm to 700 nm, even if the light emitting members 41 of this embodiment are changed to emit visible light of a different color from red, the light pattern of FIG. 8 may still be produced as the reflectivity of the reflective film 37 for light of wavelength ranging from 460 nm to 700 nm and is fairly consistent (see FIG. 7).

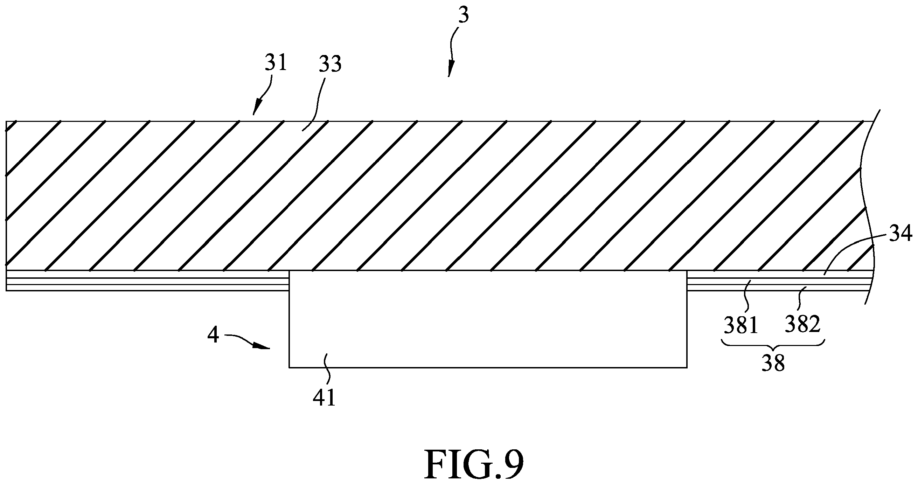

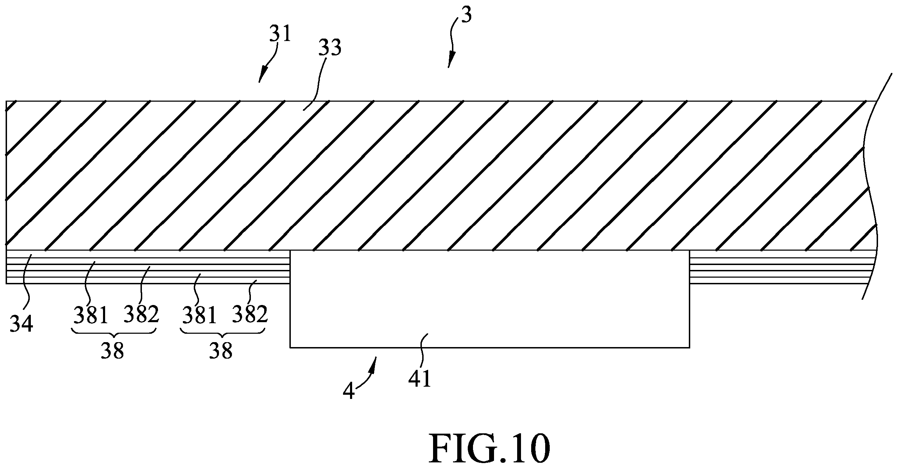

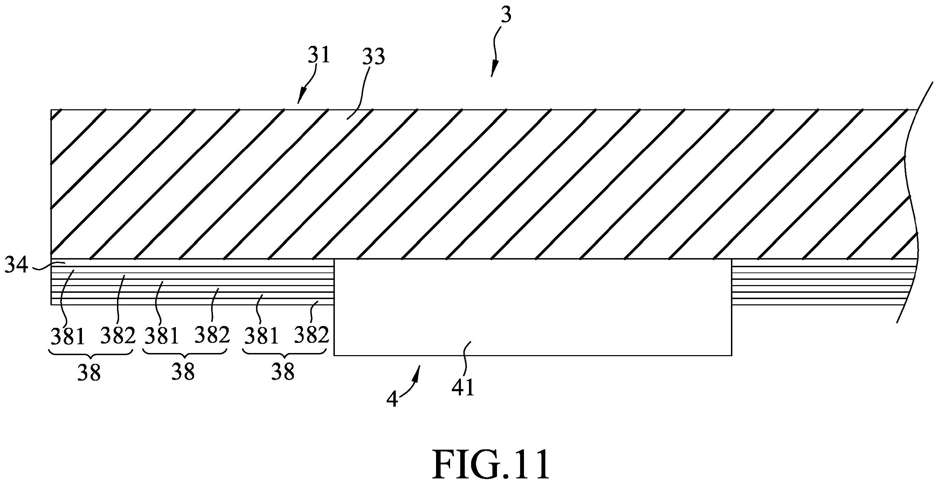

Referring to FIGS. 9 to 12, a first variation of the embodiment of the lamp device according to the invention has a structure similar to that of the embodiment, the difference being that, in the first variation, the first reflecting module 31 further includes at least one deposited film 38 formed on the aluminum film 34 and disposed between the aluminum film 34 and the second reflecting module 32. The at least one deposited film 38 has a first film layer 381 that is connected to the aluminum film 34, and a second film layer 382 that is connected to the first film layer 381 and that is disposed between the first film layer 381 and the second reflecting module 32. The first film layer 381 has a refractive index of 1.45, a thickness of 107.2 nm, and is made of silica. The second film layer 382 has a refractive index of 2.28, a thickness of 68.4 nm, and is made of titanium dioxide. Second and third variations of the lamp device according to the invention are similar to the first variation, the differences being that the first reflecting module 31 of the second variation includes two of the aforementioned deposited films 38 and that the first reflecting module 31 of the third variation includes three of the aforementioned deposited films 38. In other embodiments, the first reflecting module 31 may include a plurality of the deposited films 38 stacked on the aluminum film 34 in a direction away from the first support member 33.

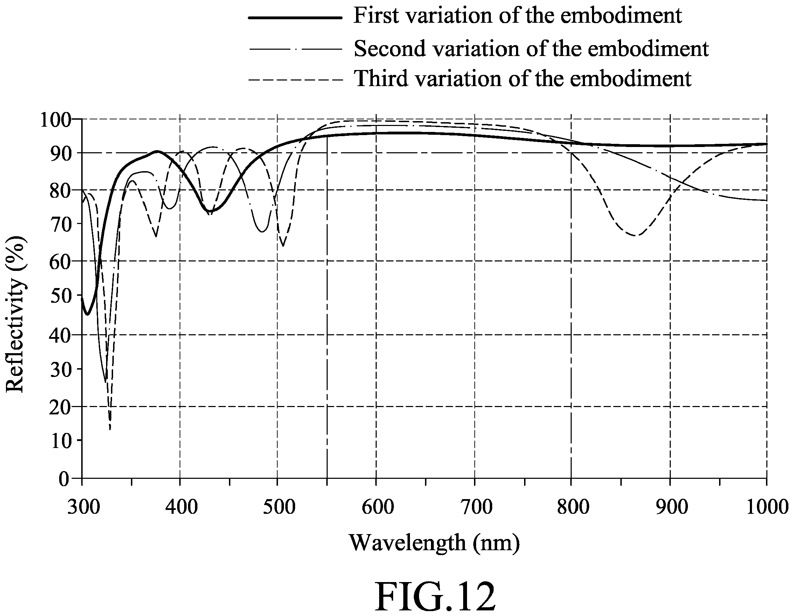

The values of reflectivity of three combined film modules each including the aluminum module 34 and the deposited film(s) 38 of the first, second and third variations of the embodiment, respectively, for light of varying wavelength are shown in FIG. 12. As can be seen, the average values of reflectivity of the combined film modules for light incident at 0° and of wavelength ranging from 550 nm to 800 nm are above 90%. More specifically, the values of reflectivity of the combined film modules of the first, second and third variations of the embodiment for visible red light of wavelength ranging from 575 nm to 675 nm are respectively 96%, 98.2% and even 99.2%. Thus, the lamp device of the first, second and third variations of the embodiment can produce more virtual images and better lighting effect.

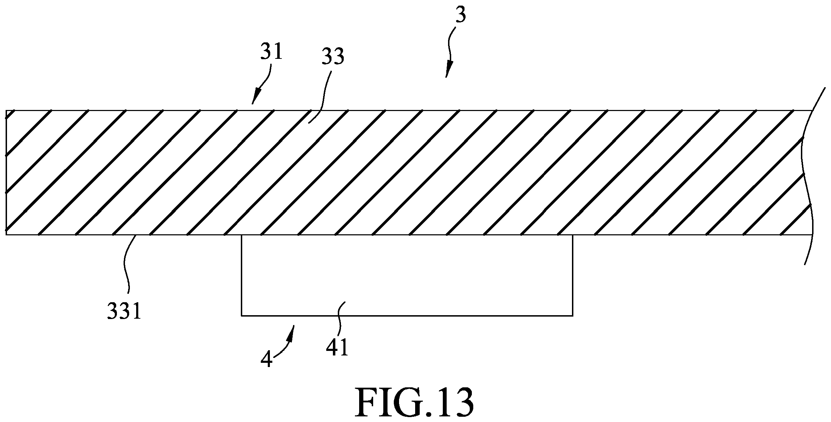

Referring to FIG. 13, a fourth variation of the embodiment of the lamp device according to the invention is similar to the embodiment, the differences being that the aluminum film 34 in the fourth variation is omitted, and that the first support member 33 of the first reflecting module 31 is made of aluminum. The first support member 33 has a polished reflecting surface 331 facing the second reflecting module 32 and has a reflectivity that is substantially over 70% for light of wavelength ranging from 550 nm to 800 nm. In this variation, the reflectivity for light of wavelength ranging from 550 nm to 800 nm is around 72%. The fourth variation shares the same benefits as the embodiment.

In sum, the lamp device of the invention has the following benefits:
1. The first reflecting module 31 can reduce the energy decay rate of light and cooperate with the second reflecting module 32 to increase the number of virtual images, thus reducing the size of the dark region 5.
2. The reflectivity/partial reflecting effect of both the first and second reflecting module 31, 32 are consistently desirable for light of wavelength ranging from 550 nm to 700 nm, thus the lamp device of this invention may be used with a variety of colors and in a wider variety of situations.

In the description above, for the purposes of explanation, numerous specific details have been set forth in order to provide a thorough understanding of the embodiment and variations. It will be apparent, however, to one skilled in the art, that one or more other embodiments may be practiced without some of these specific details.

It should also be appreciated that reference throughout this specification to "one embodiment," "an embodiment," an embodiment with an indication of an ordinal number and so forth means that a particular feature, structure, or characteristic may be included in the practice of the invention.

It should be further appreciated that in the description, various features are sometimes grouped together in a single embodiment, figure, or description thereof for the purpose of streamlining the disclosure and aiding in the understanding of various inventive aspects, and that one or more features or specific details from one embodiment may be practiced together with one or more features or specific details from another embodiment, where appropriate, in the practice of the invention.

## Claims

1. A lamp device including a reflecting unit (3) that includes a first reflecting module (31) and a second reflecting module (32), and a light emitting unit (4) that is connected to the reflecting unit (3), wherein:
said first reflecting module (31) is configured to reflect light towards said second reflecting module (32) and has a reflectivity that is substantially over 70% for light of wavelength ranging from 550 nm to 800 nm;
said second reflecting module (32) is configured to reflect light towards said first reflecting module (31) and has a reflectivity that substantially ranges from 50% to 75% for light of wavelength ranging from 460 nm to 700 nm;
said light emitting unit (4) is configured to emit light toward the reflecting unit (3) in such a way that at least a part of the light emitted by said light emitting unit (4) is reflected from one of said first reflecting module (31) and said second reflecting module (32);
said second reflecting module (32) includes a second support member (35) that is light-transmissible and coupled to said first reflecting module (31), and a reflecting film (37) that is deposited on said second support member (35) and opposite to said first reflecting module (31), said reflecting film (37) having a reflectivity substantially between 50% and 75% for light of wavelength ranging from 460 nm to 700 nm;
said reflecting film (37) includes a first deposited layer (371) formed on said second support member (35), and second, third, fourth, fifth, sixth, seventh, eighth and nine deposited layers (372, 373, 374, 375, 376, 377, 378, 379) stacked in order on said first deposited layer (371) in a direction away from said second support member (35), each of said first, third, fifth, seventh and ninth deposited layers (371, 373, 375, 377, 379) having a refractive index of 2.28, each of said second, fourth, sixth, and eighth deposited layers (272, 274, 276, 278) having a refractive index of 1.45; and
said lamp device is **characterized in that** said first deposited layer (371) has a thickness of 28.6 nm, said second deposited layer (372) having a thickness of 19.5 nm, said third deposited layer (373) having a thickness of 64.1 nm, said fourth deposited layer (374) having a thickness of 165.0 nm, said fifth deposited layer (375) having a thickness of 102.6 nm, said sixth deposited layer (376) having a thickness of 94.4 nm, said seventh deposited layer (377) having a thickness of 60.8 nm, said eighth deposited layer (378) having a thickness of 96.7 nm, said ninth deposited layer (379) having a thickness of 60.0 nm.

2. The lamp device as claimed in claim 1, **characterized in that** each of said first, third, fifth, seventh and ninth deposited layers (371, 373, 375, 377, 379) is made of titanium dioxide, and each of said second, fourth, sixth, and eighth deposited layers (272, 274, 276, 278) is made of silica.

3. The lamp device as claimed in claim 1 or 2, **characterized in that** said first reflecting module (31) includes a first support member (33) and an aluminum film (34) deposited on said first support member (33) and disposed between said first support member (33) and said second reflecting module (32), said aluminum film (34) having a reflectivity that is substantially over 85% for light of wavelength ranging from 550 nm to 800 nm.

4. The lamp device as claimed in claim 3, **characterized in that** said first reflecting module (31) further includes at least one deposited film (38) formed on said aluminum film (34) and disposed between said aluminum film (34) and said second reflecting module (32), said at least one deposited film (38) having a first film layer (381) that is connected to said aluminum film (34), and a second film layer (382) that is connected to said first film layer (381) and that is disposed between said first film layer (381) and said second reflecting module (32), said first film layer (381) having a refractive index of 1.45, said second film layer (382) having a refractive index of 2.28.

5. The lamp device as claimed in claim 4, **characterized in that** said first film layer (381) has a thickness of 107.2 nm, and said second film layer (382) has a thickness of 68.4 nm.

6. The lamp device as claimed in claim 4 or 5, **characterized in that** said first film layer (381) is made of silica, and said second film layer (382) is made of titanium dioxide.

7. The lamp device as claimed in any one of claims 4 to 6, **characterized in that** said first reflecting module (31) includes a plurality of said deposited films (38) stacked on said aluminum film (34) in a direction away from said first support member (33).

8. The lamp device as claimed in any one of claims 3 to 7, **characterized in that** said first support member (33) is made of steel.

9. The lamp device as claimed in claim 1 or 2, **characterized in that** said first reflecting module (31) includes a first support member (33) made of aluminum, said first support member (33) having a polished reflecting surface (331) facing said second reflecting module (32) and a reflectivity that is substantially over 70% for light of wavelength ranging from 550 nm to 800 nm.

10. The lamp device as claimed in any one of claims 1 to 9, **characterized in that** said second reflecting module (32) is connected to said first reflecting module (31), said light emitting unit (4) being connected to said first reflecting module (31) and emitting the light toward said second reflecting module (32).

## Patentansprüche

1. Eine Lampenvorrichtung, die eine reflektierende Einheit (3), die ein erstes reflektierendes Modul (31) und ein zweites reflektierendes Modul (32) umfasst, und eine lichtemittierende Einheit (4) umfasst, die mit der reflektierenden Einheit (3) verbunden ist, wobei:
das erste reflektierende Modul (31) dazu konfiguriert ist, Licht in Richtung des zweiten reflektierenden Moduls (32) zu reflektieren, und ein Reflexionsvermögen aufweist, das im Wesentlichen über 70 % für Licht mit einer Wellenlänge im Bereich von 550 nm bis 800 nm beträgt;
das zweite reflektierende Modul (32) dazu konfiguriert ist, Licht in Richtung des ersten reflektierenden Moduls (31) zu reflektieren, und ein Reflexionsvermögen aufweist, das im Wesentlichen im Bereich von 50 % bis 75 % für Licht mit einer Wellenlänge im Bereich von 460 nm bis 700 nm liegt;
die lichtemittierende Einheit (4) dazu konfiguriert ist, Licht in Richtung der reflektierenden Einheit (3) auf eine Weise zu reflektieren, dass zumindest ein Teil des Lichts,
das durch die lichtemittierende Einheit (4) emittiert wird, von einem des ersten reflektierenden Moduls (31) und des zweiten reflektierenden Moduls (32) reflektiert wird;
das zweite reflektierende Modul (32) ein zweites Tragbauglied (35), das lichtdurchlässig ist und mit dem ersten reflektierenden Modul (31) gekoppelt ist, und einen reflektierenden Film (37) umfasst, der auf dem zweiten Tragbauglied (35) abgeschieden ist und dem ersten reflektierenden Modul (31) gegenüberliegt, wobei der reflektierende Film (37) ein Reflexionsvermögen aufweist, das im Wesentlichen im Bereich von 50 % bis 75 % für Licht mit einer Wellenlänge im Bereich von 460 nm bis 700 nm liegt;
wobei der reflektierende Film (37) eine erste abgeschiedene Schicht (371), die auf dem zweiten Tragbauglied (35) gebildet ist, und eine zweite, dritte, vierte, fünfte, sechste, siebte, achte und neunte abgeschiedene Schicht (372, 373, 374, 375, 376, 377, 378, 379) umfasst, die der Reihe nach auf der ersten abgeschiedenen Schicht (371) in einer Richtung weg von dem zweiten Tragbauglied (35) gestapelt sind, wobei jede der ersten, dritten, fünften, siebten und neunten abgeschiedenen Schicht (371, 373, 375, 377, 379) einen Brechungsindex von 2,28 aufweist, wobei jede der zweiten, vierten, sechsten und achten abgeschiedenen Schicht (272, 274, 276, 278) einen Brechungsindex von 1,45 aufweist; und
die Lampenvorrichtung **dadurch gekennzeichnet ist, dass** die erste abgeschiedene Schicht (371) eine Dicke von 28,6 nm aufweist, die zweite abgeschiedene Schicht (372) eine Dicke von 19,5 nm aufweist, die dritte abgeschiedene Schicht (373) eine Dicke von 64,1 nm aufweist, die vierte abgeschiedene Schicht (374) eine Dicke von 165,0 nm aufweist, die fünfte abgeschiedene Schicht (375) eine Dicke von 102,6 nm aufweist, die sechste abgeschiedene Schicht (376) eine Dicke von 94,4 nm aufweist, die siebte abgeschiedene Schicht (377) eine Dicke von 60,8 nm aufweist, die achte abgeschiedene Schicht (378) eine Dicke von 96,7 nm aufweist, die neunte abgeschiedene Schicht (379) eine Dicke von 60,0 nm aufweist.

2. Die Lampenvorrichtung gemäß Anspruch 1, **dadurch gekennzeichnet ist, dass** jede der ersten, dritten, fünften, siebten und neunten abgeschiedenen Schicht (371, 373, 375, 377, 379) aus Titandioxid hergestellt ist, und jeder der zweiten, vierten, sechsten und achten abgeschiedenen Schicht (272, 274, 276, 278) aus Silika hergestellt ist.

3. Die Lampenvorrichtung gemäß Anspruch 1 oder 2, **dadurch gekennzeichnet, dass** das erste reflektierende Modul (31) ein erstes Tragbauglied (33) und einen Aluminiumfilm (34) umfasst, der auf dem ersten Tragbauglied (33) abgeschieden ist und zwischen dem ersten Tragbauglied (33) und dem zweiten reflektierenden Modul (32) angeordnet ist, wobei der Aluminiumfilm (34) ein Reflexionsvermögen aufweist, das im Wesentlichen über 85 % für Licht mit einer Wellenlänge im Bereich von 550 nm bis 800 nm beträgt.

4. Die Lampenvorrichtung gemäß Anspruch 3, **dadurch gekennzeichnet, dass** das erste reflektierende Modul (31) ferner zumindest einen abgeschiedenen Film (38) umfasst, der auf dem Aluminiumfilm (34) gebildet ist und zwischen dem Aluminiumfilm (34) und dem zweiten reflektierenden Modul (32) angeordnet ist, wobei der zumindest eine abgeschiedene Film (38) eine erste Filmschicht (381), die mit dem Aluminiumfilm (34) verbunden ist, und eine zweite Filmschicht (382) aufweist, die mit der ersten Filmschicht (381) verbunden ist und die zwischen der ersten Filmschicht (381) und dem zweiten reflektierenden Modul (32) angeordnet ist, wobei die erste Filmschicht (381) einen Brechungsindex von 1,45 aufweist, wobei die zweite Filmschicht (382) einen Brechungsindex von 2,28 aufweist.

5. Die Lampenvorrichtung gemäß Anspruch 4, **dadurch gekennzeichnet, dass** die erste Filmschicht (381) eine Dicke von 107,2 nm aufweist und die zweite Filmschicht (382) eine Dicke von 68,4 nm aufweist.

6. Die Lampenvorrichtung gemäß Anspruch 4 oder 5, **dadurch gekennzeichnet, dass** die erste Filmschicht (381) aus Silika hergestellt ist und die zweite Filmschicht (382) aus Titandioxid hergestellt ist.

7. Die Lampenvorrichtung gemäß einem der Ansprüche 4 bis 6, **dadurch gekennzeichnet, dass** das erste reflektierende Modul (31) eine Mehrzahl der abgeschiedenen Filme (38) umfasst, die auf dem Aluminiumfilm (34) in einer Richtung weg von dem ersten Tragbauglied (33) gestapelt sind.

8. Die Lampenvorrichtung gemäß einem der Ansprüche 3 bis 7, **dadurch gekennzeichnet, dass** das erste Tragbauglied (33) aus Stahl hergestellt ist.

9. Die Lampenvorrichtung gemäß Anspruch 1 oder 2, **dadurch gekennzeichnet, dass** das erste reflektierende Modul (31) ein erstes Tragbauglied (33) umfasst, das aus Aluminium hergestellt ist, wobei das erste Tragbauglied (33) eine polierte reflektierende Oberfläche (331), die dem zweiten reflektierenden Modul (32) zugewandt ist, und ein Reflexionsvermögen aufweist, das im Wesentlichen über 70 % für Licht mit einer Wellenlänge im Bereich von 550 nm bis 800 nm beträgt.

10. Die Lampenvorrichtung gemäß einem der Ansprüche 1 bis 9, **dadurch gekennzeichnet, dass** das zweite reflektierende Modul (32) mit dem ersten reflektierenden Modul (31) verbunden ist, wobei die lichtemittierende Einheit (4) mit dem ersten reflektierenden Modul (31) verbunden ist und das Licht in Richtung des zweiten reflektierenden Moduls (32) emittiert.

## Revendications

1. Dispositif de lampe comportant une unité réfléchissante (3) qui comporte un premier module réfléchissant (31) et un deuxième module réfléchissant (32), et une unité électroluminescente (4) qui est connectée à l'unité réfléchissante (3), dans lequel:
ledit premier module réfléchissant (31) est configuré pour réfléchir la lumière vers ledit deuxième module réfléchissant (32) et présente une réflectivité qui est sensiblement supérieure à 70% pour de la lumière de longueur d'onde qui est comprise entre 550 nm et 800 nm;
ledit deuxième module réfléchissant (32) est configuré pour réfléchir la lumière vers ledit premier module réfléchissant (31) et présente une réflectivité qui est comprise sensiblement entre 50% et 75% pour une lumière de longueur d'onde qui est comprise entre 460 nm et 700 nm;
ladite unité électroluminescente (4) est configurée pour émettre de la lumière vers l'unité réfléchissante (3) de sorte qu'au moins une partie de la lumière émise par ladite unité électroluminescente (4) soit réfléchie à partir de l'un parmi ledit premier module réfléchissant (31) et ledit deuxième module réfléchissant (32);
ledit deuxième module réfléchissant (32) comporte un deuxième élément de support (35) qui transmet la lumière et est couplé audit premier module réfléchissant (31), et un film réfléchissant (37) qui est déposé sur ledit deuxième élément de support (35) et opposé audit premier module réfléchissant (31), ledit film réfléchissant (37) présentant une réflectivité comprise sensiblement entre 50% et 75% pour de la lumière de longueur d'onde qui est comprise entre 460 nm et 700 nm;
ledit film réfléchissant (37) comporte une première couche déposée (371) formée sur ledit deuxième élément de support (35), et des deuxième, troisième, quatrième, cinquième, sixième, septième, huitième et neuvième couches déposées (372, 373, 374, 375, 376, 377, 378, 379) empilées dans l'ordre sur ladite première couche déposée (371) dans une direction s'éloignant dudit deuxième élément de support (35), chacune desdites première, troisième, cinquième, septième et neuvième couches déposées (371, 373, 375, 377, 379) présentant un indice de réfraction de 2,28, chacune desdites deuxième, quatrième, sixième et huitième couches déposées (272, 274, 276, 278) présentant un indice de réfraction de 1,45; et
ledit dispositif de lampe est **caractérisé par le fait que** ladite première couche déposée (371) présente une épaisseur de 28,6 nm, ladite deuxième couche déposée (372) présentant une épaisseur de 19,5 nm, ladite troisième couche déposée (373) présentant une épaisseur de 64,1 nm, ladite quatrième couche déposée (374) présentant une épaisseur de 165,0 nm, ladite cinquième couche déposée (375) présentant une épaisseur de 102,6 nm, ladite sixième couche déposée (376) présentant une épaisseur de 94,4 nm, ladite septième couche déposée (377) présentant une épaisseur de 60,8 nm, ladite huitième couche déposée (378) présentant une épaisseur de 96,7 nm, ladite neuvième couche déposée (379) présentant une épaisseur de 60,0 nm.

2. Dispositif de lampe selon la revendication 1, **caractérisé par le fait que** chacune desdites première, troisième, cinquième, septième et neuvième couches déposées (371, 373, 375, 377, 379) est réalisée en dioxyde de titane, et que chacune desdites deuxième, quatrième, sixième et huitième couches déposées (272, 274, 276, 278) est réalisée en silice.

3. Dispositif de lampe selon la revendication 1 ou 2, **caractérisé par le fait que** ledit premier module réfléchissant (31) comporte un premier élément de support (33) et un film d'aluminium (34) déposé sur ledit premier élément de support (33) et disposé entre ledit premier élément de support (33) et ledit deuxième module réfléchissant (32), ledit film d'aluminium (34) présentant une réflectivité qui est sensiblement supérieure à 85% pour de la lumière de longueur d'onde qui est comprise entre 550 nm et 800 nm.

4. Dispositif de lampe selon la revendication 3, **caractérisé par le fait que** ledit premier module réfléchissant (31) comporte par ailleurs au moins un film déposé (38) formé sur ledit film d'aluminium (34) et disposé entre ledit film d'aluminium (34) et ledit deuxième module réfléchissant (32), ledit au moins un film déposé (38) présentant une première couche de film (381) qui est connectée audit film d'aluminium (34) et une deuxième couche de film (382) qui est connectée à ladite première couche de film (381) et qui est disposée entre ladite première couche de film (381) et ledit deuxième module réfléchissant (32), ladite première couche de film (381) présentant un indice de réfraction de 1,45, ladite deuxième couche de film (382) présentant un indice de réfraction de 2,28.

5. Dispositif de lampe selon la revendication 4, **caractérisé par le fait que** ladite première couche de film (381) présente une épaisseur de 107,2 nm, et ladite deuxième couche de film (382) présente une épaisseur de 68,4 nm.

6. Dispositif de lampe selon la revendication 4 ou 5, **caractérisé par le fait que** ladite première couche pelliculaire (381) est réalisée en silice, et que ladite deuxième couche pelliculaire (382) est réalisée en dioxyde de titane.

7. Dispositif de lampe selon l'une quelconque des revendications 4 à 6, **caractérisé par le fait que** ledit premier module réfléchissant (31) comporte une pluralité desdits films déposés (38) empilés sur ledit film d'aluminium (34) dans une direction s'éloignant dudit premier élément de support (33).

8. Dispositif de lampe selon l'une quelconque des revendications 3 à 7, **caractérisé par le fait que** ledit premier élément de support (33) est réalisé en acier.

9. Dispositif de lampe selon la revendication 1 ou 2, **caractérisé par le fait que** ledit premier module réfléchissant (31) comporte un premier élément de support (33) réalisé en aluminium, ledit premier élément de support (33) présentant une surface réfléchissante polie (331) faisant face audit deuxième module réfléchissant (32) et une réflectivité qui est sensiblement supérieure à 70% pour de la lumière de longueur d'onde comprise entre 550 nm et 800 nm.

10. Dispositif de lampe selon l'une quelconque des revendications 1 à 9, **caractérisé par le fait que** ledit deuxième module réfléchissant (32) est connecté audit premier module réfléchissant (31), ladite unité électroluminescente (4) étant connectée audit premier module réfléchissant (31) et émettant la lumière vers ledit deuxième module réfléchissant (32).
